# EUROPEAN PATENT APPLICATION

(11) **EP 3 767 610 A1**
(43) Date of publication of application: **20.01.2021**
(21) Application number: 18909662.1
(22) Date of filing: 29.09.2018
(51) Int. Cl.: G09F 9/30, F16M 11/04

(54) **BENDABLE DEVICE, HOUSING, AND ELECTRONIC DEVICE**

(30) Priority: 12.03.2018 WO PCT/CN2018/078691; 12.03.2018 WO PCT/CN2018/078690; 12.03.2018 WO PCT/CN2018/078689
(71) Applicant: Shenzhen Royole Technologies Co., Ltd, Shenzhen, Guangdong 518172 (CN)
(72) Inventor: WANG, Zhengxi, Shenzhen, Guangdong 518172 (CN); CHEN, Songya, Shenzhen, Guangdong 518172 (CN); ZHANG, Qiang, Shenzhen, Guangdong 518172 (CN)
(74) Representative: Mewburn Ellis LLP
(86) International application number: PCT/CN2018/108667
(87) International publication number: WO 2019/174220

(57) **Abstract**

An electronic device is provided. The electronic device includes a flexible screen and a housing. The housing includes a first frame, a second frame, and a bendable device. The bendable device is connected between the first frame and the second frame. The flexible screen is disposed on the first frame, the second frame, and the bendable device. The bendable device is used to support the flexible screen disposed on the housing. The bendable device includes a first part, a second part, and a third part. The first part is rotatably connected with the second part via a first rotating shaft. The first part is rotatably connected with the third part via a second rotating shaft. A housing and a bendable device of the electronic device are also provided in the disclosure.

## Description

### TECHNICAL FIELD

This disclosure relates to the field of flexible screen supporting, and particularly to a bendable device capable of supporting a flexible screen, a housing provided with the bendable device, and an electronic device provided with the housing.

### BACKGROUND

With the development of flexible screens, consumers have increasing diversified and personalized demands for display methods and display effects of display devices. Compared with the traditional display device, the flexible screen is increasingly favored by consumers due to advantages of the flexible screen, for example, the flexible screen is transparent and flexible, and further the flexible screen can be bent, stretched, and designed as a curved screen. Since the foldable screen needs to be bent, existing flat-panel support structures are obviously unable to satisfy the bending requirements of the foldable screen. Therefore, it is necessary to provide a support structure capable of satisfying the bending requirements of the foldable screen.

### SUMMARY

Implementations of the disclosure provide a bendable device capable of satisfying the bending requirements of flexible screens, a housing provided with the bendable device, and an electronic device provided with the housing.

The bendable device provided in implementations of the disclosure includes a first part, a second part, and a third part. The first part is rotatably connected with the second part via a first rotating shaft. The first part is rotatably connected with the third part via a second rotating shaft.

The housing provided in implementations of the disclosure includes a first frame, a second frame, and a bendable device. The bendable device includes a first part, a second part, and a third part. The first part is rotatably connected with the second part via a first rotating shaft. The first part is rotatably connected with the third part via a second rotating shaft.

The electronic device provided in implementations of the disclosure includes a flexible screen and a housing. The housing includes a first frame, a second frame, and a bendable device. The bendable device is connected between the first frame and the second frame. The flexible screen is disposed on the first frame, the second frame, and the bendable device. The bendable device is used to support the flexible screen disposed on the housing. The bendable device includes a first part, a second part, and a third part. The first part is rotatably connected with the second part via a first rotating shaft. The first part is rotatably connected with the third part via a second rotating shaft.

In the bendable device of the electronic device provided herein, the first part is rotatably connected with the second part via the first rotating shaft. The first part is rotatably connected with the third part via the second rotating shaft, and thus the bendable device can support the foldable screen, that is, the bendable device is a support structure capable of satisfying the bending requirements of the foldable screen.

### BRIEF DESCRIPTION OF THE DRAWINGS

To describe technical solutions in implementations of the disclosure more clearly, the following briefly introduces accompanying drawings required for illustrating the implementations. Apparently, the accompanying drawings in the following description illustrate some implementations. Those of ordinary skill in the art may also obtain other drawings based on these accompanying drawings without creative efforts.
FIG. 1 is a perspective view of an electronic device according to implementations of the disclosure.
FIG. 2 is a perspective view of the electronic device in FIG. 1 without a back plate, viewed from another viewpoint.
FIG. 3 is a perspective view of a bendable device of the electronic device in FIG. 1.
FIG. 4 is a partially exploded perspective view of the bendable device in FIG. 3.
FIG. 5 is an exploded, perspective view of a hinge body of the electronic device in FIG. 4.
FIG. 6 is a partially assembled perspective view of the hinge body of the electronic device in FIG. 5.
FIG. 7 is an exploded, perspective view of a gear mechanism of the electronic device in FIG. 4.
FIG. 8 is an exploded, perspective view of a damping member of the electronic device in FIG. 7.

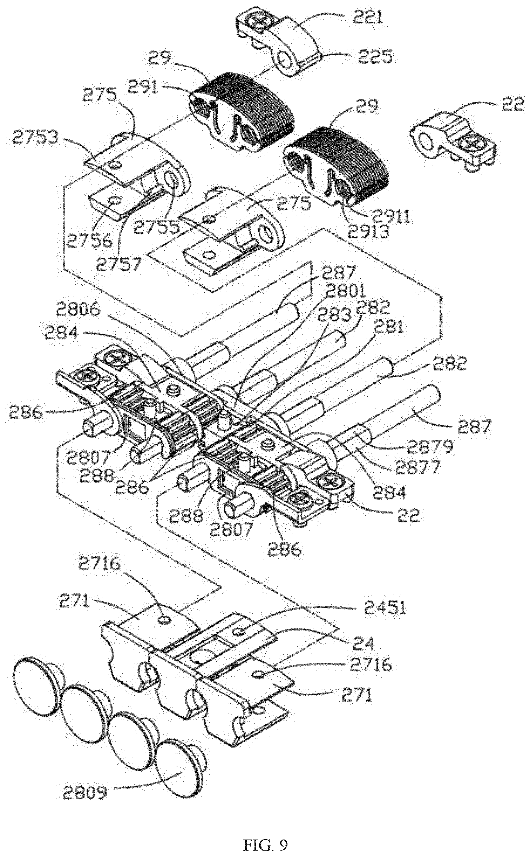

FIG. 9 is a partially assembled perspective view of the bendable device in FIG. 7.

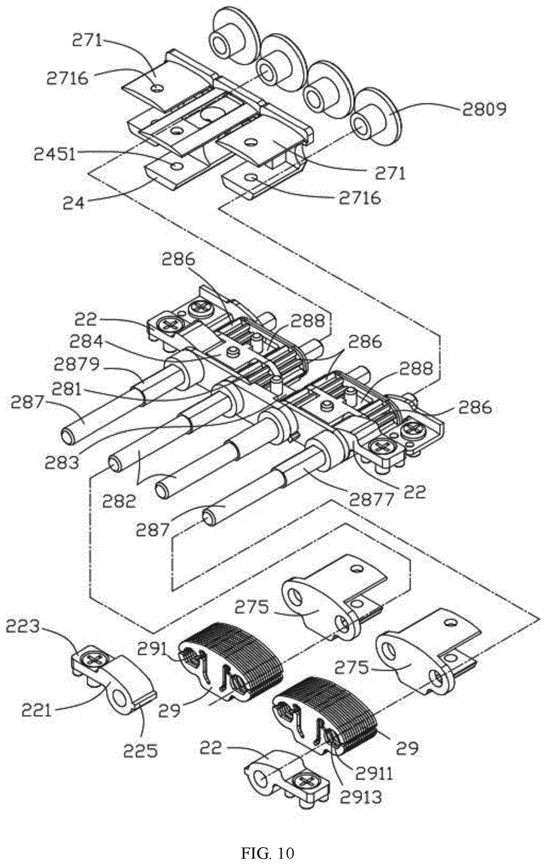

FIG. 10 is a perspective view of the bendable device in FIG. 9, viewed from another viewpoint.

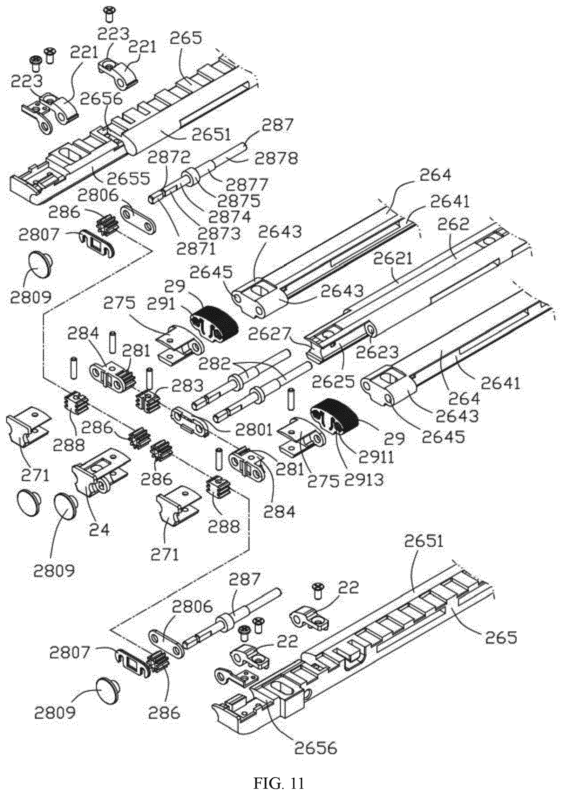

FIG. 11 is a partially exploded perspective view of the bendable device in FIG. 4.

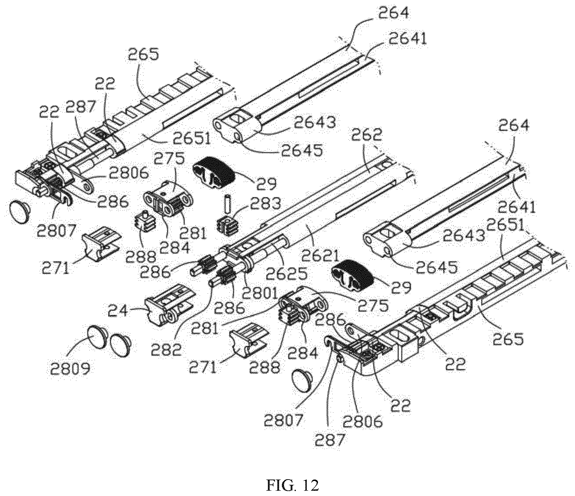

FIG. 12 is a partially assembled view of the bendable device in FIG. 11.

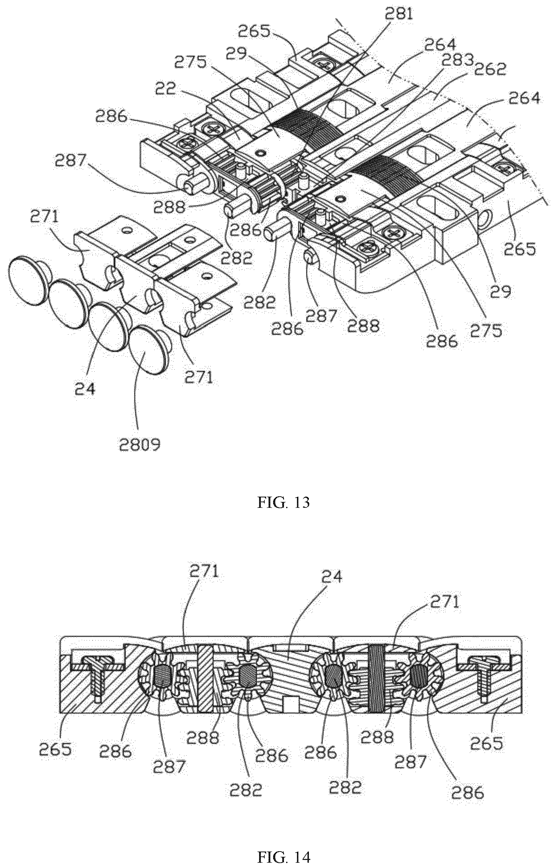

FIG. 13 is an assembled view of the bendable device in FIG. 12.
FIG. 14 is a cross-sectional view of the bendable device in FIG. 3, taken along line XIV-XIV.
FIG. 15 is a cross-sectional view of the bendable device in FIG. 3, taken along line xv-xv
FIG. 16 is a perspective view of the bendable device of the electronic device in FIG. 1, the bendable device being in folded status.
FIG. 17 is a cross-sectional view of the bendable device in FIG. 16, taken along line XVII-XVII.
FIG. 18 is a cross-sectional view of the bendable device in FIG. 16, taken along line XVIII-XIII.

### DETAILED DESCRIPTION

Hereinafter, technical solutions embodied in implementations of the disclosure will be described in a clear and comprehensive manner in conjunction with the accompanying drawings. It is obvious that implementations described herein are merely some rather than all of the implementations of the disclosure. All other implementations obtained by those of ordinary skill in the art based on the implementations of the disclosure without creative efforts shall fall within the protection scope of the disclosure.

In the following description, it should be understood that directions or positional relationships indicated by terms "upper", "lower", "left", and "right" are based on directions or positional relationships illustrated in the accompany drawings. The terms are merely for the convenience of describing the disclosure and simplifying the description, and do not indicate or imply that the device or elements indicated must have a specific orientation and need to be constructed and operated in the specific orientation. Therefore, the terms cannot be understood as a restriction on this disclosure.

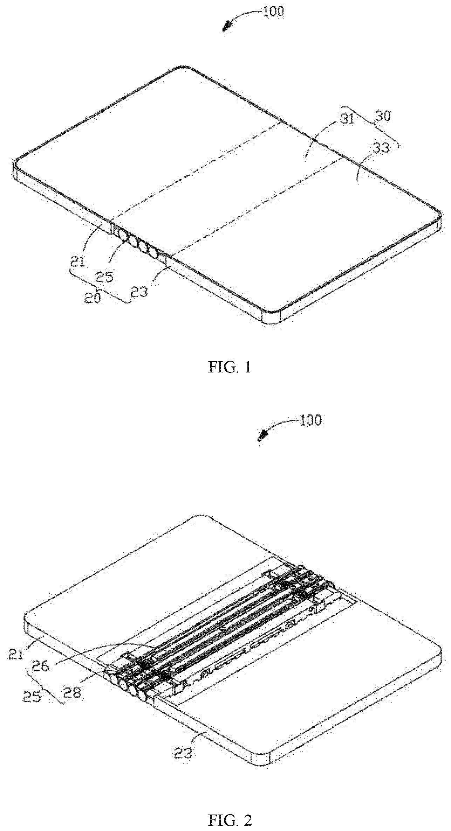

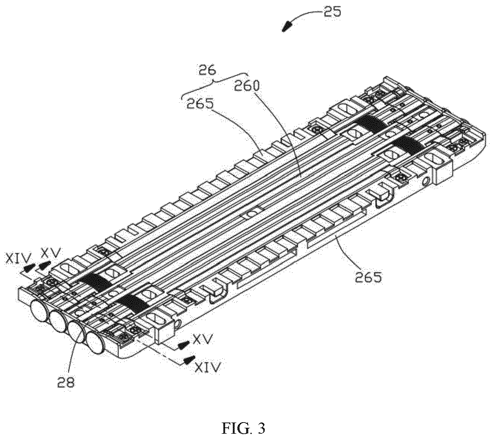

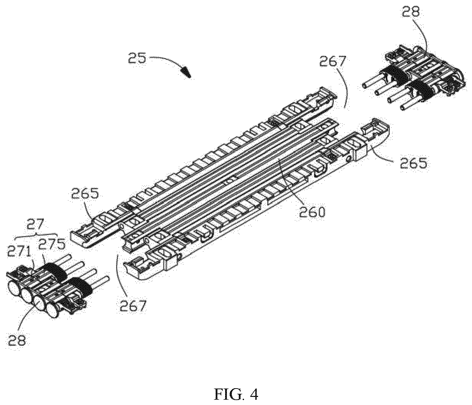

Referring to FIG. 1 to FIG. 4, FIG. 1 is a perspective view of an electronic device according to implementations of the disclosure. FIG. 2 is a perspective view of the electronic device in FIG. 1 without a back plate, viewed from another viewpoint. FIG. 3 is a perspective view of a bendable device of the electronic device in FIG. 1. FIG. 4 is a partially exploded perspective view of the bendable device in FIG. 3. The electronic device 100 in an implementation of the disclosure includes a housing 20 and a flexible screen 30 disposed on the housing 20. The housing 20 includes a first frame 21, a second frame 23, and a bendable device 25 connected between the first frame 21 and the second frame 23. The flexible screen 30 is disposed on the first frame 21, the second frame 23, and the bendable device 25. The flexible screen 30 includes a bendable region 31 disposed on the bendable device 25 and two non-bendable regions 33 connected with two opposite sides of the bendable region 31. The bendable device 25 is configured for supporting the flexible screen 30. The bendable device 25 includes a first part, a second part, and a third part. The first part is rotatably connected with the second part via a first rotating shaft, and the first part is rotatably connected with the third part via a second rotating shaft. The first part, the second part, and the third part may be chain links in a hinge. Alternatively, the first part, the second part, and the third part may be a gear set, a link frame, a positioning plate, or the like. In at least one implementation, the first part is a second chain link 264, the second part is a first chain link 262, the third part is a connection link 265, the first rotating shaft is a first connecting shaft 282, and the second rotating shaft is a second connecting shaft 287. In one example, the bendable device 25 includes a rotating shaft mechanism 26 and two gear mechanisms 28 respectively disposed at two opposite ends of the rotating shaft mechanism 26. The rotating shaft mechanism 26 is disposed between the first frame 21 and the second frame 23. The rotating shaft mechanism 26 includes a hinge body 260 and two connection links 265 which are respectively hinged on two opposite sides of the hinge body 260. The hinge body 260 and each connection link 265 are connected via the gear mechanism 28. In one example, the two connection links 265 are disposed on the two opposite sides of the hinge body 260, and respectively rotatably connected with the hinge body 260 via the two gear mechanisms 28.

According to implementations, the electronic device 100 is a mobile phone. It can be understood that in other implementations, the electronic device 100 may be, but is not limited to, a radiophone, a beeper, a web browser, a notepad, a calendar, and/or a personal digital assistant (PDA) of a receiver of a global positioning system (GPS).

The hinge body 260 of the bendable device 25 of the electronic device 100 provided herein and the two connection links 265 are connected with each other via the gear mechanisms 28. Due to the high machining accuracy of the gear mechanism 28, the overall tolerance of the bendable device 25 may be reduced, and thus it is convenient to install the bendable device 25 between the first frame 21 and the second frame 23 of the electronic device 100, thereby avoiding the failure of installation of the flexible screen 30 or damage to the flexible screen 30 due to the large overall tolerance of the bendable device 25. Therefore, the bendable device 25 is a support structure that can meet bending requirements of the flexible screen 30.

Each of the two connection links 265 extends beyond both ends of the hinge body 260, so that the two connection links 265 and each end of the hinge body 260 can collectively define a mounting space 267. The mounting space 267 can receive the gear mechanism 28. Each gear mechanism 28 is installed in a corresponding mounting space 267, to make the structure of the bendable device 25 be compact, the arrangement of the elements be reasonable, and the machining accuracy be high.

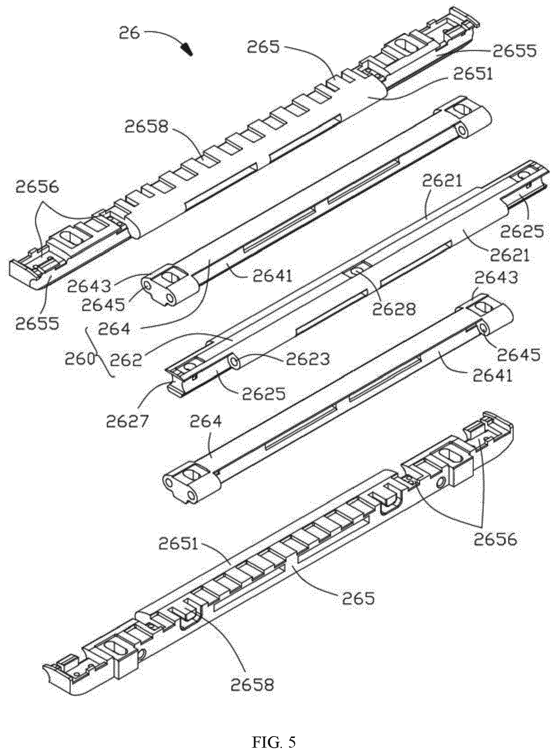

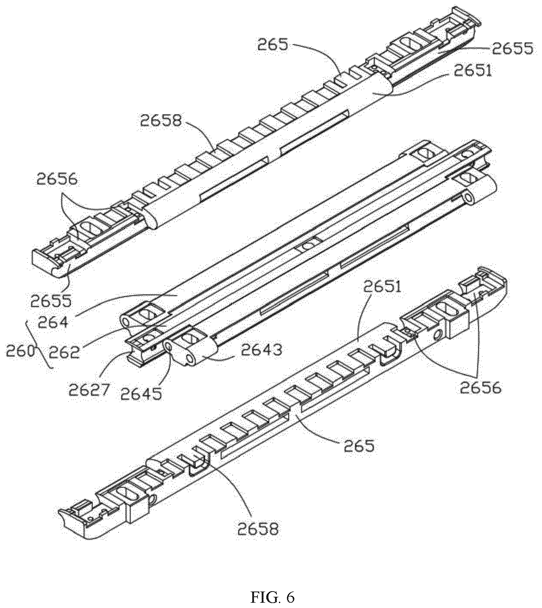

As illustrated in FIG. 5 and FIG. 6, FIG. 5 is an exploded, perspective view of a hinge body of the electronic device in FIG. 4, and FIG. 6 is a partially assembled perspective view of the hinge body of the electronic device in FIG. 5.

The hinge body 260 includes a first chain link 262 and two second chain links 264 disposed on two opposite sides of the first chain link 262. The first chain link 262 and one second chain link 264 are hinged via a gear mechanism 28. The two connection links 265 are respectively hinged on the two opposite sides of the hinge body 260 through the gear mechanisms 28. That is, each connection link 265 is rotatably connected with a side of a corresponding second chain link 264 away from the first chain link 262.

A cylindrical connection strip 2621 protrudes from the middle of each of the two opposite sides of the first chain link 262. Each connection strip 2621 extends along a length direction of the first chain link 262. Two opposite ends of each connection strip 2621 each axially define a connection hole 2623 The first chain link 262 defines a receiving groove 2625 at an end of each of the two opposite sides, and each receiving groove 2625 is adjacent to an end surface of a corresponding connection strip 2621. A cross section of each receiving groove 2625 is circular arc-shaped. An axial line of the receiving groove 2625 coincides with that of the connection hole 2623 of the corresponding connection strip 2621. The first chain link 262 defines a clamping slot 2627 on each of two opposite end surfaces. The first chain link 262 defines multiple mounting holes 2628 on a front surface of the first chain link 262, and the multiple mounting holes 2628 are configured for connecting the bendable device 25 to the flexible screen 30.

Each second chain link 264 defines a connection groove 2641 on each of two opposite sides of the second chain link 264, and the connection groove 2641 extends along a length direction of the second chain link 264. The connection groove 2641 is configured for rotatably receiving a corresponding connection strip 2621 of the first chain link 262. A cross section of each connection groove 2641 is circular arc-shaped. An outer surface of each connection strip 2621 of the first chain link 262 can be relatively slidably attached to an inner surface of a corresponding connection groove 2641. A connection strip 2643 protrudes from each of two opposite sides of two opposite ends of each second chain link 264. Each connection strip 2643 extends along the length direction of the second chain link 264. An outer surface of each connection strip 2643 is circular arc-shaped. Each connection strip 2643 can be rotatably received in a corresponding receiving groove 2625 of the first chain link 262. The outer surface of the connection strip 2643 can be relatively slidably attached to an inner surface of the receiving groove 2625. Each connection strip 2643 defines a connection hole 2645 at an end of the connection strip 2643. The connection hole 2645 extends along the length direction of the second chain link 264 and penetrates through the connection strip 2643. An axial line of the connection hole 2645 coincides with that of the connection groove 2641.

A connection strip 2651 protrudes from the middle of a side of each connection link 265 facing the hinge body 260. The connection strip 2651 extends along the length direction of the hinge body 260. An outer surface of the connection strip 2651 is circular arc-shaped. Each connection strip 2651 can be rotatably received in a connection groove 2641 of a corresponding second chain link 264. The outer surface of the connection strip 2651 can be relatively slidably attached to an inner surface of the connection groove 2641. Each connection link 265 defines two receiving grooves 2655 at a side facing the hinge body 260, and the two receiving grooves 2655 are respectively adjacent to two opposite ends of the connection strip 2651. Each receiving groove 2655 is configured for rotatably receiving a connection strip 2643 of a corresponding second chain link 264. The outer surface of the connection strip 2643 can be relatively slidably attached to an inner surface of the receiving groove 2655. Each connection link 265 defines multiple fixing grooves 2656 on a front surface of each connection link 265, and the fixing grooves 2656 are adjacent to the two opposite ends of the connection strip 2651. Each fixing groove 2656 defines a connection hole on a bottom surface of the fixing groove 2656. Each connection link 265 is provided with a connecting portion(s) 2658 on a side away from the connection strip 2651. The connecting portion(s) 2658 may be connected to the first frame 21 or the second frame 23.

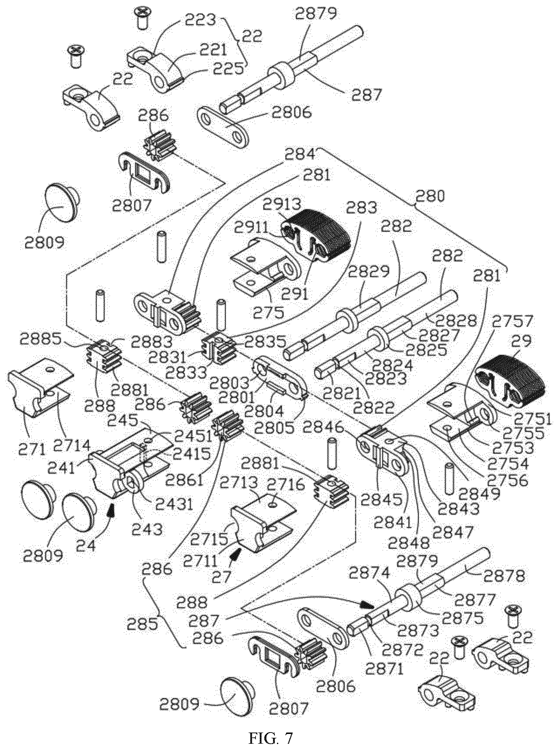

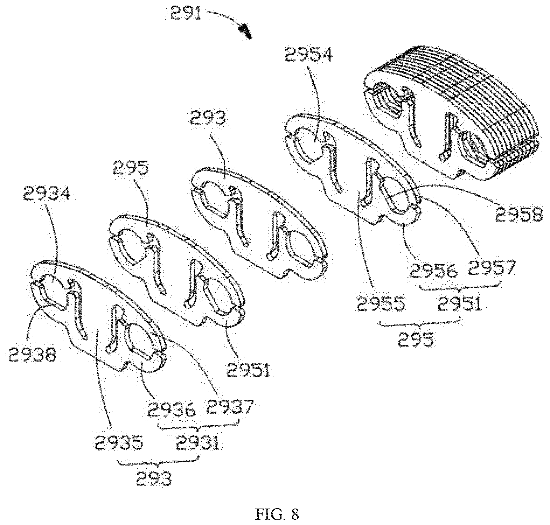

Referring to FIG. 7 and FIG. 8, FIG. 7 is an exploded, perspective view of a gear mechanism of the electronic device in FIG. 4, and FIG. 8 is an exploded, perspective view of a bendable device of the electronic device in FIG. 4. The first part, the second part, and the third part of the bendable device 25 are linked by a linkage mechanism. When the second part rotates relative to the first part, the second part drives the linkage mechanism to move, and the linkage mechanism drives the third part to rotate relative to the second part. The linkage mechanism includes a first transmission group. The first transmission group includes a first transmission member sleeved on the first rotating shaft and a second transmission member rotatably connected with the first transmission member. When the second transmission member rotates, the second transmission member drives the whole first transmission group to rotate around the first rotating shaft. According to implementations, the first transmission group is a second gear assembly 285. The first transmission member is a gear of the second gear assembly 285. The second transmission member is another gear of the second gear assembly 285. That is, the first transmission member and the second transmission member are two second gears 286 of the second gear assembly 285. When a gear of the second gears 286 rotates around its own axis, the gear drives the whole second gear assembly 285 to rotate around the first connecting shaft 282. The gear mechanism 28 includes a first gear assembly 280 connected to the second chain links 264 and a second gear assembly 285 connected between each second chain link 264 and a connection link 265 corresponding to the second chain link 264. The bendable device 25 further includes a second transmission group. The second transmission group includes a first transmission part sleeved on the first rotating shaft, a second transmission part sleeved on the second rotating shaft, and a third transmission part. The first transmission part is sleeved on the first rotating shaft, and the first transmission part is close to the first transmission member. The first transmission part is rotatably connected with the first rotating shaft, and the first transmission member is secured to the first rotating shaft. A connecting member is interposed between the first transmission part and the first transmission member. The first transmission part is secured to the connecting member, and the first transmission member is rotatably connected with the connecting member. The first rotating shaft passes through the connecting member. When the second transmission member rotates, the second transmission member drives the connecting member to rotate around the first rotating shaft. The first transmission part and the connecting member are secured to each other. When the connecting member rotates around the first rotating shaft, the connecting member drives the first transmission part to rotate around the first rotating shaft. The third transmission part is disposed between the first transmission part and the second transmission part. The third transmission part is engaged with the first transmission part and the second transmission part, respectively. When the first transmission part rotates around the first rotating shaft, the first transmission part drives the third transmission part to slide, and the third transmission part drives the second transmission part to rotate around the second rotating shaft.

According to implementations, the second transmission group is the first gear assembly 280, the first transmission part and the second transmission part are two first gears 281 of the first gear assembly 280, the third transmission part is a first rack 283, and the connecting member is a link frame 284. In one example, the first gear assembly 280 includes two first gears 281, two first connecting shafts 282, a first rack 283, two link frames 284, and a connecting plate 2801. The two first connecting shafts 282 are respectively connected with the two second chain links 264. Each second chain link 264 is rotatably connected with a corresponding first connecting shaft 282. The two first gears 281 are sleeved on and rotatably connected with the two first connecting shafts 282, respectively. The first rack 283 is provided with racks 2831 on two opposite sides. The first rack 283 is disposed between the two first gears 281, and the racks 2831 on the two opposite sides of the first rack 283 are respectively engaged with the two first gears 281. The third transmission part includes a straight rack. Two opposite sides of the straight rack are engaged with the first transmission part and the second transmission part, respectively. According to implementations, the first gear 281 is a spur gear, and the first rack 283 is a straight rack. The racks of the first rack 283 are disposed on two opposite sides (that is, the left and right sides) of the first rack 283. Racks on each side of the first rack 283 are arranged at intervals along a height direction (i.e., an up-down direction) of the first rack 283, and each rack extends along a length direction of the first connecting shaft 282. Tooth portions of each first gear 281 are arranged at intervals surrounding an axial direction of the first gear 281. Each tooth portion extends along the length direction of the first connecting shaft 282. Each rack 2831 and each tooth portion of the first gear 281 are both parallel to the first connecting shaft 282. The axial direction of the first gear 281 is the same as that of the first connecting shaft 282. Each first connecting shaft 282 includes a first securing section 2821 at one end of the first connecting shaft 282, a second securing section 2823 axially located at the rear end of the first securing section 2821, and a first rotating shaft section 2824 axially located at the rear end of the second securing section 2823, a spacer plate 2825 axially at the rear end of the first rotating shaft section 2824, a positioning section 2827 axially located at the rear end of the spacer plate 2825, and a second rotating shaft section 2828 axially located at the rear end of the positioning section 2827. The first connecting shaft 282 defines a clamping groove 2822 between the first securing section 2821 and the second securing section 2823. An outer peripheral surface of the positioning section 2827 includes an engagement surface 2829, and the engagement surface 2829 extends along the length direction of the first connecting shaft 282.

The first rack 283 is rectangular. The first rack 283 defines a guide groove 2833 on a side away from the hinge body 260, and the guide groove 2833 extends along a height direction of the first rack 283. The first rack 283 defines a guide hole 2835 at the middle of a top surface of the first rack 283, and the guide hole 2835 is arranged between two racks 2831. The guide hole 2835 extends along a direction parallel to the height direction of the first rack 283 (i.e., perpendicular to the length direction of the first connecting shaft 282). The guide hole 2835 penetrates through the first rack 283.

The bendable device 25 further includes a third rotating shaft passing through the second transmission member, a connection link sleeved on the third rotating shaft, and a connecting member connected with the first transmission group. The second transmission member is secured to the third rotating shaft, and the connection link is secured to the third rotating shaft. When the connection link rotates around the third rotating shaft, the third rotating shaft drives the second transmission member to rotate synchronously. The first rotating shaft passes through the connecting member. When the second transmission member rotates, the second transmission member drives the connecting member to rotate around the first rotating shaft. According to implementations, the second transmission member is a second gear 286, the connection link is a connection link 265, and the third rotating shaft is the other second connecting shaft 287. When the connection link 265 rotates around the first connecting shaft 282, the first connecting shaft 282 drives the first gear 281 to rotate synchronously. The connecting member includes a link frame 284.

Each link frame 284 includes a positioning plate 2841, a connecting block 2843 protruding from the middle of a side of the positioning plate 2841 facing the hinge body 260, and a guide strip 2845 protruding from a side of the positioning plate 2841 away from the connecting block 2843. Two opposite end surfaces of the positioning plate 2841 are shaped in circular arc. The positioning plate 2841 defines two axial holes 2846 respectively on two opposite ends of the positioning plate 2841. The connecting block 2843 and one end of the positioning plate 2841 cooperatively define a receiving space 2847. The first gear 281 is fixed in the receiving space 2847, and an axial hole of the first gear 281 directly faces a corresponding axial hole 2846. The connecting block 2843 and the other end of the positioning plate 2841 cooperatively define the other receiving space 2847, and a stop block 2848 is disposed in the other receiving space 2847. The stop block 2848 is used to limit the rotation range of the second connecting shaft 287. The first gear 281 can be fixed on the positioning plate 2841 by welding, gluing, or the like. A penetration hole of the first gear 281 is aligned with one of the two axial holes 2846. The penetration hole of the first gear 281 and the axial holes 2846 are round. The connecting block 2843 defines a fixing hole 2849 on a top surface of the connecting block 2843, and the fixing hole 2849 is arranged between the two receiving spaces 2847. The fixing hole 2849 penetrates through the connecting block 2843 along a direction perpendicular to an axial line of the axial hole of the first gear 281. The guide strip 2845 extends along a direction parallel to the fixing hole 2849.

The connecting plate 2801 is rectangular. Two opposite end surfaces of the connecting plate 2801 are shaped in circular arc. The connecting plate 2801 defines a through hole 2803 on each of two opposite ends of the connecting plate 2801. A connecting block 2804 protrudes from the middle of each of two opposite sides of the connecting plate 2801. The connection blocks 2804 are disposed between two through holes 2803. A stop block 2805 extends from each of the two opposite end surfaces of the connecting plate 2801.

The first transmission group further includes a third transmission member disposed between the first transmission member and the second transmission member. The third transmission member is engaged with the first transmission member and the second transmission member, respectively. In at least one implementation, the third transmission member includes a straight rack. The first transmission member and the second transmission member are engaged with two opposite sides of the straight rack, respectively. According to implementations, the first transmission member and the second transmission member are the two second gears 286, and the third transmission member is a second rack 288. In one example, each second gear assembly 285 includes two second gears 286, a second connecting shaft 287 that can be connected to a connection link 265, and a second rack 288. The second rack 288 is provided with racks 2881 on two opposite sides of the second rack 288. The racks 2881 can be respectively engaged with the two second gears 286. A fixing hole 2861 is defined in the center of each second gear 286, and the fixing hole is non-rotationally symmetrical.

The second rack 288 is rectangular. The second rack 288 defines a guide groove 2883 on a side facing the hinge body 260, and the guide groove 2883 extends along a direction parallel to the racks 2881. The guide groove 2883 corresponds to a guide strip 2845 of a corresponding link frame 284. The second rack 288 defines a guide hole 2885 at the middle of a top surface, and the guide hole 2885 is arranged between two racks 2881. The guide hole 2885 penetrates through the second rack 288 along a direction parallel to the guide groove 2883. The racks of the second rack are disposed on the two opposite sides (that is, the left and right sides) of the second rack. Racks on each side of the second rack are arranged discontinuously along a height direction (i.e., an up-down direction) of the second rack, and each rack extends along the length direction of the first connecting shaft 282. When the second transmission member rotates, the second transmission member drives the third transmission member to slide, and the third transmission member drives the whole first transmission group to rotate around the first connecting shaft 282. That is, when one of the two second gears 286 rotates, the one of the second gears 286 drives the second rack 288 to slide, and the other of the two second gears 286 drives the whole second gear assembly 285 to rotate around the first connecting shaft 282.

The second connecting shaft 287 and the first connecting shaft 282 have a similar structure. The second connecting shaft 287 includes a first securing section 2871 at one end of the second connecting shaft 287, a second securing section 2873 axially located at the rear end of the first securing section 2871, and a first rotating shaft section 2874 axially located at the rear end of the second securing section 2873, a spacer plate 2875 axially at the rear end of the first rotating shaft section 2874, a positioning section 2877 axially located at the rear end of the spacer plate 2875, and a second rotating shaft section 2878 axially located at the rear end of the positioning section 2877. The second connecting shaft 287 defines a clamping groove 2872 between the first securing section 2871 and the second securing section 2873. An outer peripheral surface of the positioning section 2877 includes an engagement surface 2879, and the engagement surface 2879 extends along the length direction of the second connecting shaft 287.

The bendable device further includes a third rotating shaft that passes through the second transmission member. The second transmission member is secured to the third rotating shaft. According to implementations, the third rotating shaft is the other second connecting shaft 287. The other second connecting shaft 287 passes through a corresponding second gear 286, and the second gear 286 is secured to the second connecting shaft 287 corresponding to the second gear 286.

The bendable device 25 further includes a third transmission group. The third transmission group includes a second transmission component sleeved on the second rotating shaft and a first transmission component rotatably connected with the second transmission component. When the second transmission part rotates around the second rotating shaft, the second transmission part drives the whole third transmission group to rotate around the second rotating shaft, and drives the first transmission component to rotate around an axis of the first transmission component. The third transmission group further includes a third transmission component engaged between the first transmission component and the second transmission component. When the second transmission part rotates around the second rotating shaft, the second transmission component remains fixed and has no rotation, and the third transmission component drives the first transmission component to rotate around an axis of the first transmission component. The third transmission component includes a straight rack. When the second transmission part rotates around the second rotating shaft, the third transmission component slides, and drives the first transmission component to rotate around the axis of the first transmission component. According to implementations, the third transmission group is the other second gear assembly 285, the first transmission component and the second transmission component are two second gears 286 of the other second gear assembly 285, and the third transmission component is a second rack 288 of the other second gear assembly 285.

The gear mechanism 28 further includes a washer 2806 and a lap piece 2807 that are connected between each second gear assembly 285 and the first gear assembly 280, and multiple shaft covers 2809. The washer 2806 is rectangular. Two opposite end surfaces of the washer 2806 are circular arc-shaped. The washer 2086 defines through holes respectively on two opposite ends of the washer 2086. The lap piece 2807 is rectangular. Two opposite end surfaces of the lap piece 2807 are circular arc-shaped. The lap piece 2807 defines a bayonet on each of two opposite ends of the lap piece 2807.

The bendable device 25 further includes multiple fixing pieces 22, a first positioning frame 24 sleeved on the first gear assembly 280, a second positioning frame 27 sleeved on each second gear assembly 285, and two damping members 29. The fixing pieces 22 are used to connect the second connecting shaft 287 of each second gear assembly 285 to a corresponding connection link 265. Each fixing piece 22 includes a cylindrical fixing column 221, a connecting block 223 extending from one side of the fixing column 221, and a stop block 225 extending from the other side of the fixing column 221. The fixing column 221 axially defines a fixing hole. The connecting block 223 defines a connection hole. The first positioning frame 24 includes a positioning strip 241, two positioning pieces 243 respectively extending from two opposite sides of the positioning strip 241, and two lap pieces 245 respectively extending from the top and the bottom of one side of the positioning strip 241. Each positioning piece 243 defines a positioning hole 2431. A connection hole 2451 is defined at the middle of each of the two lap pieces 245. A guide strip protrudes from a side of the positioning strip 241 of the first positioning frame 24 facing the first rack 283, and the guide strip corresponds to the guide groove 2833 of the first rack 283. The guide strip can be slidably received in the guide groove 2833.

Each second positioning frame 27 includes a first positioning member 271 and a second positioning member 275. The first positioning member 271 includes a positioning plate 2711 and two connecting plates 2713 protruding from one side of the positioning plate 2711, where the two connecting plates 2713 are spaced apart from and opposite to each other. The two connecting plates 2713 collectively define a connection groove 2714. The positioning plate 2711 defines a notch 2715 on each of two opposite sides. The two connecting plates 2713 each define a connection hole 2716. The second positioning member 275 includes a positioning plate 2751 and two connecting plates 2753 protruding from one side of the positioning plate 2751, where the two connecting plates 2753 are spaced apart from and opposite to each other. The two connecting plates 2753 collectively define a connection groove 2754. The positioning plate 2751 defines a through hole 2755 on each of two opposite sides of the positioning plate 2751. The two connecting plates 2753 each define a connection hole 2756. A connecting block is arranged between the two connecting plates 2753 and adjacent to the positioning plate 2751. A stop block 2757 protrudes from each of two opposite sides of the connecting block.

The two damping members 29 are operable to provide a damping force during rotation of the bendable device 25. Each damping member 29 defines two damping holes 291. The first connecting shafts 282 and the second connecting shafts 287 are respectively inserted in and connected with damping holes 291 of the two damping members 29. The first connecting shaft 282 is in interference fit with a corresponding damping hole 291, and the second connecting shaft 287 is in interference fit with a corresponding damping hole 291. The damping holes 291 have damping effects on the first connecting shafts 282 and the second connecting shafts 287.

An inner peripheral surface of each damping hole 291 includes a first positioning surface 2911 and a second positioning surface 2913. The first positioning surface 2911 and the second positioning surface 2913 are both planar and cooperatively define an angle. The engagement surface 2829 of each first connecting shaft 282 can be attached to a first positioning surface 2911 or a second positioning surface 2913 of a corresponding damping hole 291, and the engagement surface 2879 of each second connecting shaft 287 can be attached to a first positioning surface 2911 or a second positioning surface 2913 of a corresponding damping hole 291. In one example, when the bendable device 25 is unfolded, the engagement surface 2829 of the first connecting shaft 282 is attached to the first positioning surface 2911 of the corresponding damping hole 291, and the engagement surface 2879 of the second connecting shaft 287 is attached to the first positioning surface 2911 of the corresponding damping hole 291, and the first positioning surface 2911 is used to keep the bendable device 25 in unfolded status, thereby positioning the second connecting shaft 287 at a first position relative to the damping member. When the bendable device 25 is completely bent, the engagement surface 2829 of the first connecting shaft 282 is attached to the second positioning surface 2913 of the corresponding damping hole 291, and the engagement surface 2879 of the second connecting shaft 287 is attached to the second positioning surface 2913 of the corresponding damping hole 291, and the second positioning surface 2913 is used to keep the bendable device 25 in folded status, thereby positioning the second connecting shaft at a second position relative to the damping member. When the bendable device 25 is in the unfolded status and the folded status, an aperture of each damping hole 291 has an initial length, that is, the aperture of the damping hole 291 has no expansion or contraction, and the damping hole 291 is not elastically deformed. In such a case, a damping force between each damping hole 291 and the corresponding first connecting shaft 282 or between each damping hole 291 and the corresponding second connecting shaft 287 is minimum, so as to facilitate the flexible device 25 to rotate the first connecting shaft 282 and the second connecting shaft 287.

As illustrated in FIG. 8, FIG. 8 is an exploded, perspective view of a damping member of the electronic device in FIG. 7. In an implementation, each damping member 291 includes multiple first elastic pieces 293 and multiple second elastic pieces 295. Each first elastic piece 293 includes two circlips 2931 and a connecting portion 2935 connected between the two circlips 2931. That is, the two circlips 2931 are respectively arranged at two opposite sides of the connecting portion 2935. Each circlip 2931 includes a first elastic shoulder 2936 and a second elastic shoulder 2937 respectively protruding from two opposite ends of the connecting portion 2935. The first elastic shoulder 2936 and the second elastic shoulder 2937 collectively define a through hole 2934. The first elastic shoulder 2936 is provided with a first positioning sub-surface 2938 on an inner peripheral surface of the through hole 2934.

Each second elastic piece 295 includes two circlips 2951 and a connecting portion 2955 connected between the two circlips 2951. That is, the two circlips 2951 are respectively arranged at two opposite sides of the connecting portion 2955. Each circlip 2951 includes a first elastic shoulder 2956 and a second elastic shoulder 2957 respectively protruding from two opposite ends of the connecting portion 2955. The first elastic shoulder 2956 and the second elastic shoulder 2957 collectively define a through hole 2954. The first elastic shoulder 2956 is provided with a second positioning sub-surface 2958 on an inner peripheral surface of the through hole 2954.

The multiple first elastic pieces 293 and the multiple second elastic pieces 295 are alternately stacked. The through holes 2934 defined on the circlips 2931 of each first elastic piece 293 directly faces the through holes 2954 defined on the circlips 2951 of each second elastic piece 295 respectively, such that through holes 2934 and through holes 2954 at the same end of the damping member 29 collectively define a damping hole 291. The first positioning sub-surfaces 2938 of the first elastic pieces 293 are coplanar, thereby forming the first positioning surface 2911 of the damping hole 291. The second positioning sub-surfaces 2958 of the second elastic pieces 295 are coplanar, thereby forming the second positioning surface 2913 of the damping hole 291.

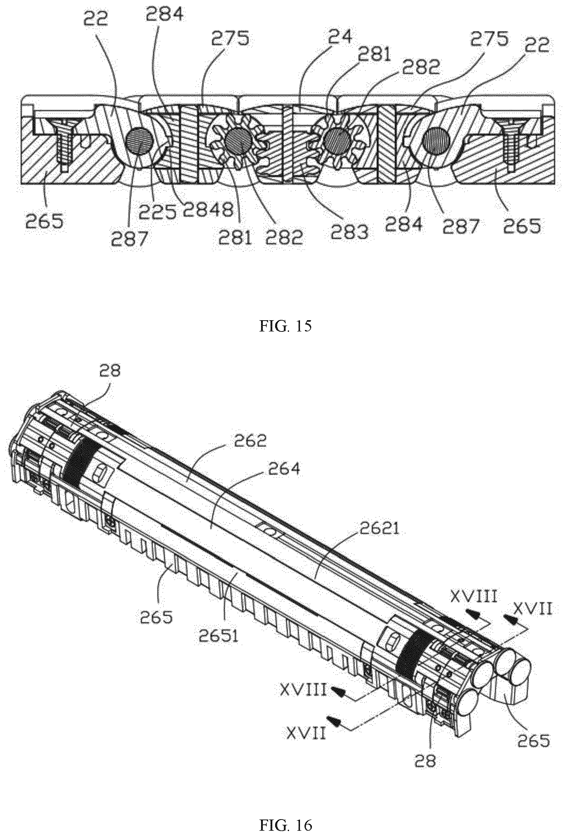

Referring to FIG. 5 and FIG. 15, during assembling the bendable device 25, the end of each second connecting shaft 287 having the first securing section 2871 is sequentially inserted in a through hole of the washer 2806, the fixing hole of one of the multiple fixing pieces 22, an axial hole 2846 of an end of the link frame 284 away from the first gear 281, and a second gear 286. In this case, the washer 2806, the fixing piece 22, and the link frame 284 are sequentially sleeved on and connected with the first rotating shaft section 2874 of the second connecting shaft 287. The washer 2806 abuts against the spacer plate 2875 of the second connecting shaft 287. The second gear 286 is sleeved on and connected with the second securing section 2873 of the second connecting shaft 287, and the second gear 286 is fixed relative to the second connecting shaft 287. The fixing piece 22 can be fixed to the first rotating shaft section 2874 by welding or the like, so that the fixing piece 22 and the first rotating shaft section 2874 can rotate synchronously. The second gear 286 can rotate following the rotation of the second connecting shaft 287. A through hole 2755 of one second positioning member 275 is sleeved, on the positioning section 2877 of the second connecting shaft 287 from the second rotating shaft section 2878 of the second connecting shaft 287, so that the link frame 284 is clamped between the two connecting plates 2753 of the second positioning member 275. That is, the link frame 284 is received in the connection groove 2754 of the second positioning member 275, and the connection holes 2756 of the second positioning member 275 directly face the fixing hole 2849 of the link frame 284. A damping hole 291 of one damping member 29 is sleeved, on the positioning section 2877 of the second connecting shaft 287 from the second rotating shaft section 2878 of the second connecting shaft 287, so that the first positioning surface 2911 of the damping member 29 is attached to the engagement surface 2879 of the positioning section 2877, and the positioning section 2877 of the second connecting shaft 287 is in interference fit with the damping hole 291.

The end of each of the two first connecting shafts 282 having the first securing section 2821 is sequentially inserted in a through hole 2803 of the connecting plate 2801, a through hole of the washer 2806, the first gear 281 of the link frame 284, the axial hole 2846 of the link frame 284, and the second gear 286. The first rack 283 is engaged between the two first gears 281. Each second rack 288 is engaged between two corresponding second gears 286. The second gear 286 is fixed to the second securing section 2823 of the first connecting shaft 282, that is, the first transmission member is secured to the first rotating shaft. The guide strip 2845 of each link frame 284 can be relatively slidably received in the guide groove 2883 of the corresponding second rack 288. The bayonets of the lap piece 2807 are respectively clamped in the clamping groove 2822 of the first connecting shaft 282 and the clamping groove 2872 of a corresponding second connecting shaft 287, so that each first connecting shaft 282 is connected with the corresponding second connecting shaft 287. The two first positioning members 271 are respectively sheathed on the two second racks 288, so that each second rack 288 is received in the connection groove 2714 of the corresponding first positioning member 271, and the guide hole 2885 of the second rack 288 directly faces the connection holes 2716 of the first positioning member 271, to facilitate a fixing member to pass through, thereby fixing the second rack 288 and the first positioning member 271. The first positioning frame 24 is sheathed on the first rack 283 so that the first rack 283 is received between the lap pieces 245 of the corresponding first positioning frame 24, and the guide hole 2835 of the first rack 283 directly faces the connection holes 2451 of the first positioning frame 24, so as to facilitate a fixing member to pass through, thereby fixing the first rack 283 and the first positioning frame 24. The first securing section 2821 of each of the two first connecting shafts 282 is inserted in the positioning hole 2431 of one of the positioning pieces 243 of the first positioning frame 24. The two lap pieces 245 of the first positioning frame 24 are respectively connected with the connecting blocks 2804 of the connecting plate 2801. The guide groove 2833 of the first rack 283 receives the guide stripe 2415 of the first positioning frame 24, such that the first rack 283 can slide relatively up and down along the guide strip 2415 of the first positioning frame 24.

The positioning section 2827 of each first connecting shaft 282 having the second rotating shaft section 2828 is inserted in and connected with the through hole 2755 of an end of one of the two second positioning member 275 away from the connection link 265 and a damping hole 291 of one of the two damping members 29. At this point, the stop blocks 2805 on the two opposite ends of the connecting plate 2801 respectively correspond to the stop blocks 2757 of the two second positioning members 275. The positioning section 2827 of each first connecting shaft 282 is in interference fit with the corresponding damping hole 291, and the engagement surface 2829 of the first connecting shaft 282 is attached to the first positioning surface 2911 of the corresponding damping member 29. The link frame 284 is secured to the second positioning member 275 by inserting a fixed lock in the connection holes 2756 of the second positioning member 275 and the fixing hole 2849 of the link frame 284. The fixing column 221 of one of the fixing pieces 22 is received in the receiving space 2847 of the link frame 284, such that the stop block 225 of the fixing member 22 corresponds to the stop block 2848 of the link frame 284. The two connecting plates 2713 of the first positioning member 271 are connected with the corresponding link frame 284, and the guide groove 2883 of the second rack 288 receives the guide strip 2845 of the link frame 284, such that the second rack 288 can slide relatively up and down along the corresponding guide strip 2845.

The above various components/elements are combined to obtain the gear mechanism 28. Two second gears 286 are fixed to the second connecting shafts 287 to rotate with the second connecting shafts 287. The link frame 284 can be rotatably sleeved on the second connecting shaft 287. The damping member 29 is sleeved on the second connecting shaft 287 in an interference manner. The first gear 281 is fixed to the link frame 284 to drive the link frame 284 to rotate together. Other second gears 286 are fixed to the first connecting shafts 282 to rotate with the first connecting shafts 282. The link frame 284 can be rotatably sleeved on the first connecting shaft 282, and the damping member 29 is sleeved on the first connecting shaft 282 in an interference manner. The second rack 288 can be slidably interposed between two adjacent second gears 286. The first rack 283 can be slidably interposed between the two adjacent first gears. The two first connecting shafts 282 are both fixed to the first positioning frame 24, so that the two second gears 286 respectively fixed to the two first connecting shafts 282 are also relatively fixed.

The above-mentioned gear mechanism 28 can be linked, that is, rotation of a specific component/element can drive other components/elements to rotate, thereby resulting in bending of the entire gear mechanism. For example, under the condition that the first positioning frame 24 is taken as a reference and set to be motionless, when the second gear 286 on the right side is enabled to rotate around an axis of the second gear 286, the tooth portions of the second gear 286 are engaged with the racks of the second rack 288, thereby driving the second rack 288 to slide upwardly. The racks of the second rack 288 are engaged with the second gear 286 adjacent to the second rack 288 and on the left side of the second rack 288. Since the second gear 286 adjacent to the second rack 288 and on the left side of the second rack 288 is caused to be fixed by the first positioning frame 24 and the first connecting shaft 282, the second rack 288 drives the link frame 284 and the damping member 29 to rotate around the first connecting shaft 282 during the upward sliding of the second rack 288. Since the first gear 281 is fixed on the link frame 284, the rotation of the link frame 284 also drives the first gear 281 to rotate synchronously, and the first gear 281 then drives the first rack 283 to slide because the tooth portions of the first gear 281 are engaged with the racks of the first rack 283. The sliding of the first rack 283 further drives the other first gear 281 adjacent to the first rack 283 to rotate, and the rotation of the other first gear 281 drives the other link frame 284 to rotate. Since the other first connecting shaft 282 and another second gear 286 sleeved on the other first connecting shaft 282 are both kept fixed, the rotation of the other link frame 284 then drives the other second rack 288 to slide, and the other second rack 288 further drives the second gear 286 on the left most side to rotate. In this way, the linkage of the entire gear mechanism 28 is realized. In the linkage process, the gear mechanism 28 is bent synchronously.

According to implementations, since the linkage is achieved by engaging the straight racks with the spur gears, compared with the method that the linkage is achieved by engaging helical gears, high manufacturing accuracy is not required, which can effectively reduce production costs and improve production efficiency.

It can be understood that straight racks in each gear set can also be replaced by helical gears or spur gears, and the spur gears in each gear set can also be replaced by helical gears. Alternatively, the straight racks in each gear set may be removed, and the engagement may be completed via two spur gears, and therefore the linkage can also be achieved.

The two second chain links 264 are respectively disposed on the two opposite sides of the first chain link 262. In this way, the connection strips 2621 on the two opposite sides of the first chain link 262 are rotatably received in the connecting grooves 2641 of the two second chain links 264 respectively. The connection strips 2643 of each second chain link 264 can be rotatably received in the receiving grooves 2625 of the first chain link 262 respectively, such that the connection holes 2645 defined on the connection strips 2643 directly face the connection holes 2623. The hinge body 260 is disposed between the two connection links 265. With this configuration, the connection strip 2651 of each of the two connection links 265 can be rotatably received in connection groove 2641 in the side of one of the two second chain links 264 away from the first chain link 262. The connection strips 2643 of each second chain link 264 are received in the receiving grooves 2655 of the corresponding connection link 265 respectively. The second rotating shaft section 2878 of the second connecting shaft 287 is inserted in the connection hole 2645 of the corresponding second chain link 264. The fixing hole of the other fixing piece 22 is sleeved on and connected with the second rotating shaft section 2878 of the second connecting shaft 287, and then the connecting blocks 223 of the two fixing pieces 22 on the second connecting shaft 287 are respectively fixed to the fixing grooves 2656 of the connection link 265. That is, multiple fasteners respectively pass through the connecting blocks 223 to be locked in the connection holes of the fixing grooves 2656, enabling that the second connecting shaft 287 and the second gear 286 are connected to the connection link 265. The fixing piece 22 can be fixed to the second rotating shaft section 2828 of the second connecting shaft 287 by welding, or the fixing piece 22 can be fixed to the second rotating shaft section 2828 by other means as long as the fixing piece can rotate with the second rotating shaft section 2828. The second rotating shaft section 2828 of each of the two first connecting shafts 282 passes through the corresponding connection holes 2645 of one of the two second chain links 264, such that the connection holes 2645 directly face the connection holes 2623 corresponding to the first chain link 262. The middle of the connecting plate 2801 is clamped in and secured to the clamping slot 2627 of the first chain link 262. The first securing sections 2821 of the first connecting shafts 282 and the first securing sections 2871 of the second connecting shafts 287 are respectively received in the notches 2715 of the second positioning frames 27, and then multiple shaft covers 2809 are respectively arranged on ends of the first connecting shafts 282 and the second connecting shafts 287. That is, the multiple shaft covers 2809 can be clamped in and connected with the first securing sections 2821 of the first connecting shafts 282 and the first securing sections 2871 of the second connecting shafts 287.

The bendable device 25 assembled is disposed between the first frame 21 and the second frame 23. That is, the connecting portions 2658 of the two connection links 265 are respectively connected with the first frame 21 and the second frame 23. Back surfaces of the two non-bendable regions 33 of the flexible screen 30 are respectively attached to the first frame 21 and the second frame 23. A back surface of the bendable region 31 of the flexible screen 30 is attached to a front surface of the bendable device 25. The mounting holes 2628 of the first chain link 262 are connected to the back surface of the flexible screen 30. In such a case, the first chain link 262 of the bendable device 25 is fixed to the back surface of the flexible screen 30, the first chain link 262 does not rotate, and the bendable region 31 of the flexible screen 30 can be bent with the bending of the bendable device 25.

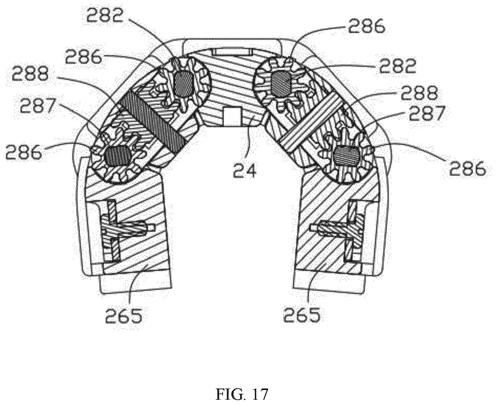

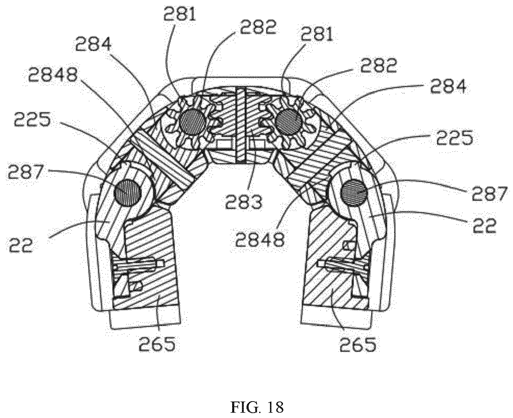

Referring to FIG. 16 to FIG. 18, FIG. 16 is a perspective view of the bendable device of the electronic device in FIG. 1, the bendable device being in folded status, FIG. 17 is a cross-sectional view of the bendable device in FIG. 16, taken along line XVII-XVII, and FIG. 18 is a cross-sectional view of the bendable device in FIG. 16, taken along line XVIII-XIII. During bending the electronic device 100, a bending force is applied to at least one of the first frame 21 and the second frame 23 of the electronic device 100, so that the connection links 265 connected to the first frame 21 and the second frame 23 rotate toward each other (in an opposite direction). That is, the second connecting shaft 287 fixed on each connection link 265 rotates relative to the corresponding second chain link 264 so that the connection link 265 is bent toward a side away from the flexible screen 30 relative to the corresponding second chain link 264. The second gear 286 on each second connecting shaft 287 rotates with the connection link 265 and the second connecting shaft 287 relative to the corresponding second chain link 264, and the second gear 286 drives the corresponding second rack 288 to move toward the flexible screen 30. Since the first connecting shaft 282 is fixed to the first chain link 262, and the second gear 286 is fixed to the first connecting shaft 282, the second gear 286 is fixed and has no rotation, and the second rack 288 can only rotate around the second gear 286 to move away from the flexible screen 30, so that the link frame 284 and the first gear 281 can rotate around the first connecting shaft 282, and thus the second chain link 264 is bent toward the side away from the flexible screen 30 relative to the first chain link 262. The link frame 284 rotates around the first connecting shaft 282 to drive the first gear 281 to rotate, the first gear 281 drives the first rack 283 to move toward the flexible screen 30 until back surfaces of the first frame 21 and the second frame 23 are attached to each other. During bending the bendable device, the circlips 2931 of the damping members 29 respectively apply damping forces to the first connecting shafts 282 and the second connecting shafts 287 until the engagement surfaces 2829 of the first connecting shafts 282 and the engagement surfaces 2879 of the second connecting shafts 287 are attached to the second positioning surfaces 2913. At this point, the bendable device 25 is bent, and the flexible screen 30 is also bent following bending of the bendable device 25. Therefore, the front surface of the first chain link 262, front surfaces of the two second chain links 264, and front surfaces of the two connection links 265 are connected with each other to form an arched surface. That is, the front surface of the first chain link 262, the front surfaces of the two second chain links 264, and the front surfaces of the two connection links 265 share a circular arc surface to facilitate the fitting of the flexible screen 30.

When the electronic device 100 needs to be flattened, the first frame 21 and the second frame 23 are pulled outwardly, so that the connection links 265 connected to the first frame 21 and the second frame 23 rotate away from each other. That is, the second connecting shaft 287 fixed on each connection link 265 rotates relative to the corresponding second chain link 264. In other words, the connection link 265 is bent toward a side of the flexible screen 30 relative to the corresponding second chain link 264. The second gear 286 on each second connecting shaft 287 rotates with the second connecting shaft 287 relative to the corresponding second chain link 264, so that the second gear 286 can drive the corresponding second rack 288 to move away from the flexible screen 30. Since the first connecting shaft 282 is fixed on the first chain link 262, and the second gear 286 is fixed on the first connecting shaft 282, the second gear 286 is fixed and does not rotate, and the second rack 288 can only rotate around the second gear 286 to move toward the flexible screen 30, so that the link frame 284 and the first gear 281 can rotate around the first connecting shaft 282, and therefore the second chain link 264 is bent toward the flexible screen 30 relative to the first chain link 262. The first gear 281 rotates to drive the first rack 283 to move away from the flexible screen 30, so that the link frame 284 and the corresponding first gear 281 rotate around the first connecting shaft 282 until the bendable device 25 is flattened. During unfolding the bendable device, the circlips of the damping members 29 respectively apply damping forces to the first connecting shafts 282 and the second connecting shafts 287 until the engagement surfaces 2829 of the first connecting shafts 282 and the engagement surfaces 2879 of the second connecting shafts 287 are attached to the first positioning surfaces 2911. In this case, the bendable device 25 is in horizontal status, and the flexible screen 30 can be flattened with the bendable device 25. A fixing piece 22 can relatively slide in the receiving space 2847 of the corresponding link frame 284, and the stop block 225 of the fixing piece 22 abuts against the stop block 2848 of the link frame 284. A fixing piece 22 can slide between the two connecting plates 2753 of the corresponding second positioning member 275, and the stop block 225 of the fixing piece 22 abuts against the stop block 2757 of the second positioning member 275 to limit the rotation range of the connection links 265 and the second chain links 264.

It can be understood that the term "relative sliding" in the disclosure does not limit the direct contact and relative sliding of two components/elements, but may also include relative sliding between two components/elements in which a third-party component/element is inserted. The third-party component/element is not limited to a physical component, such as a sheet, a membrane, or the like, but can also include a non-physical component, such as gap, space, etc., or a combination of the physical component and the non-physical component. The third-party component is not limited to one third-party component, but may include multiple third-party components. That is to say, as long as the two components/elements have a relative sliding, regardless of the actual positions of the two components/elements, they can be considered to fall within the scope of the "relative sliding" of the disclosure.

The above are the exemplary implementations of the disclosure. It should be noted that for those of ordinary skill in the art, without departing from the principle of the disclosure, various improvements and modifications can be made. These improvements and modifications also fall within the protection scope of the disclosure.

## Claims

1. A bendable device, comprising:
a first part;
a second part rotatably connected with the first part via a first rotating shaft; and
a third part rotatably connected with the first part via a second rotating shaft.

2. The bendable device of claim 1, wherein the first part, the second part, and the third part are linked by a linkage mechanism, when the second part rotates relative to the first part, the second part drives the linkage mechanism to move, and the linkage mechanism drives the third part to rotate relative to the second part.

3. The bendable device of claim 2, wherein the linkage mechanism comprises a first transmission group, wherein the first transmission group comprises a first transmission member sleeved on the first rotating shaft, and a second transmission member rotatably connected with the first transmission member, wherein when the second transmission member rotates, the second transmission member drives the whole first transmission group to rotate around the first rotating shaft.

4. The bendable device of claim 3, wherein the second transmission member comprises a gear, wherein when the gear rotates around an axis of the gear, the gear drives the whole first transmission group to rotate around the first rotating shaft.

5. The bendable device of claim 3, wherein the first transmission group further comprises a third transmission member disposed between the first transmission member and the second transmission member, wherein the third transmission member is engaged with the first transmission member and the second transmission member, respectively.

6. The bendable device of claim 5, wherein when the second transmission member rotates, the second transmission member drives the third transmission member to slide, and the third transmission member drives the whole first transmission group to rotate around the first rotating shaft.

7. The bendable device of claim 5, wherein the third transmission member comprises a straight rack, wherein the first transmission member and the second transmission member are engaged with two opposite sides of the straight rack, respectively.

8. The bendable device of claim 6, wherein the first transmission member remains fixed and has no rotation during sliding of the third transmission member.

9. The bendable device of claim 3, wherein the first transmission member is fixed to the first rotating shaft.

10. The bendable device of claim 3, further comprising a third rotating shaft passing through the second transmission member, wherein the second transmission member is fixed to the third rotating shaft.

11. The bendable device of claim 10, further comprising a connection link sleeved on the third rotating shaft, wherein the connection link is secured to the third rotating shaft, and when the connection link rotates around the third rotating shaft, the third rotating shaft drives the second transmission member to rotate synchronously.

12. The bendable device of any of claims 3 to 11, further comprising a connecting member connected with the first transmission group, wherein the first rotating shaft passes through the connecting member, and when the second transmission member rotates, the second transmission member drives the connecting member to rotate around the first rotating shaft.

13. The bendable device of claim 12, further comprising a first transmission part, wherein the first transmission part is sleeved on the first rotating shaft and close to the first transmission member.

14. The bendable device of claim 13, wherein the first transmission part is rotatably connected with the first rotating shaft, and the first transmission member is fixed to the first rotating shaft.

15. The bendable device of claim 13, further comprising a connecting member interposed between the first transmission part and the first transmission member, wherein the first transmission part is secured to the connecting member, and the first transmission member is rotatably connected with the connecting member.

16. The bendable device of any of claims 3 to 11, further comprising a second transmission group, wherein the second transmission group comprises a first transmission part sleeved on the first rotating shaft and a second transmission part sleeved on the second rotating shaft.

17. The bendable device of claim 16, wherein the first transmission part is rotatably connected with the first rotating shaft.

18. The bendable device of claim 16, further comprising a connecting member connected with the first transmission group, wherein the first rotating shaft passes through the connecting member, and when the second transmission member rotates, the second transmission member drives the connecting member to rotate around the first rotating shaft.

19. The bendable device of claim 18, wherein the first transmission part is secured to the connecting member, and when the connecting member rotates around the first rotating shaft, the connecting member drives the first transmission part to rotate around the first rotating shaft.

20. The bendable device of claim 17, wherein the first transmission part is rotatably connected with the second transmission part, and when the first transmission part rotates around the first rotating shaft, the first transmission part drives the second transmission part to rotate around the second rotating shaft.

21. The bendable device of claim 20, wherein a direction in which the first transmission part rotates around the first rotating shaft is opposite to that in which the second transmission part rotates around the second rotating shaft.

22. The bendable device of claim 17, wherein the second transmission group further comprises a third transmission part, wherein the third transmission part is disposed between the first transmission part and the second transmission part, and the third transmission part is engaged with the first transmission part and the second transmission part, respectively.

23. The bendable device of claim 22, wherein when the first transmission part rotates around the first rotating shaft, the first transmission part drives the third transmission part to slide, and the third transmission part drives the second transmission part to rotate around the second rotating shaft.

24. The bendable device of claim 23, wherein the third transmission part comprises a straight rack, wherein the first transmission part and the second transmission part are engaged with two opposite sides of the straight rack, respectively.

25. The bendable device of claim 16, further comprising a third transmission group, wherein the third transmission group comprises:
a second transmission component sleeved on the second rotating shaft; and
a first transmission component rotatably connected with the second transmission component.

26. The bendable device of claim 25, wherein when the second transmission part rotates around the second rotating shaft, the second transmission part drives the whole third transmission group to rotate around the second rotating shaft, and drives the first transmission component to rotate around an axis of the first transmission component.

27. The bendable device of claim 25, wherein the third transmission group further comprises a third transmission component engaged between the first transmission component and the second transmission component, wherein when the second transmission part rotates around the second rotating shaft, the second transmission component remains fixed and has no rotation, and the third transmission component drives the first transmission component to rotate around an axis of the first transmission component.

28. The bendable device of claim 27, wherein the third part comprises a straight rack, and when the second transmission part rotates around the second rotating shaft, the third transmission component slides, and drives the first transmission component to rotate around the axis of the first transmission component.

29. The bendable device of claim 10 or 11, further comprising a damping member sleeved on the first rotating shaft and the third rotating shaft, wherein the damping member is operable to provide a damping force during rotation of the first transmission group around the first rotating shaft.

30. The bendable device of claim 29, wherein the damping member defines two damping holes, wherein the first rotating shaft is inserted in and connected with one of the two damping holes, and the third rotating shaft is inserted in and connected with the other of the two damping holes, wherein the first rotating shaft is in interference fit with the one of the two damping holes, and the third rotating shaft is in interference fit with the other of the two damping holes.

31. The bendable device of claim 30, wherein
an inner peripheral surface of each of the two damping holes comprises a first positioning surface and a second positioning surface that cooperatively define an angle;
the first rotating shaft and the third rotating shaft each are provided with an engagement surface;
when the bendable device is in unfolded status, the engagement surface of the first rotating shaft is attached to the first positioning surface of the one of the two damping holes, and the engagement surface of the third rotating shaft is attached to the first positioning surface of the other of the two damping holes; and
when the bendable device is in folded status, the engagement surface of the first rotating shaft is attached to the second positioning surface of the one of the two damping holes, and the engagement surface of the third rotating shaft is attached to the second positioning surface of the other of the two damping holes.

32. The bendable device of claim 31, wherein the damping member comprises:
a plurality of first elastic pieces, where each of the plurality of first elastic pieces comprises two circlips; and
a plurality of second elastic pieces, wherein each of the plurality of second elastic pieces comprises two circlips; wherein
the plurality of first elastic pieces and the plurality of second elastic pieces are alternately stacked, the two circlips of each of the plurality of first elastic pieces directly face the two circlips of each of the plurality of second elastic pieces, respectively, wherein the first rotating shaft is inserted in and in interference fit with circlips of the plurality of first elastic pieces and the plurality of second elastic pieces, and the third rotating shaft is inserted in and in interference fit with circlips of the plurality of first elastic pieces and the plurality of second elastic pieces.

33. The bendable device of claim 32, wherein an inner peripheral surface of each of the two circlips of each of the plurality of first elastic pieces comprises a first positioning sub-surface, and an inner peripheral surface of each of the two circlips of each of the plurality of second elastic pieces comprises a second positioning sub-surface, wherein all first positioning sub-surfaces are coplanar and collectively form the first positioning surface, and all second positioning sub-surfaces are coplanar and collectively form the second positioning surface.

34. The bendable device of claim 33, wherein each of the plurality of first elastic pieces comprises a strip-shaped connecting portion, and the two circlips of each of the plurality of first elastic pieces are arranged on two opposite sides of the connecting portion, and wherein each of the two circlip comprises a first elastic shoulder and a second elastic shoulder respectively protruding from two opposite ends of the connecting portion, wherein the first elastic shoulder and the second elastic shoulder collectively define a through hole, and the first rotating shaft and the third rotating shaft are able to be inserted in and connected with the through holes, respectively.

35. A housing, comprising:
a first frame;
a second frame; and
the bendable device of any of claims 1 to 34, wherein the bendable device is connected between the first frame and the second frame.

36. An electronic device, comprising:
a flexible screen; and
the housing of claim 35, wherein the flexible screen is disposed on the housing.
